(19) Europäisches Patentamt
European Patent Office
Office européen des brevets

(11) **EP 2 569 656 B1**

(12) **FASCICULE DE BREVET EUROPEEN**

(45) Date de publication et mention
de la délivrance du brevet:
**26.02.2014 Bulletin 2014/09**

(21) Numéro de dépôt: **11725143.9**

(22) Date de dépôt: **10.05.2011**

(51) Int Cl.:
*B25J 15/06* (2006.01)     *G01R 33/00* (2006.01)
*G01V 3/10* (2006.01)

(86) Numéro de dépôt international:
**PCT/FR2011/051044**

(87) Numéro de publication internationale:
**WO 2011/141672 (17.11.2011 Gazette 2011/46)**

(54) **DISPOSITIF DE DETECTION ET DE DENOMBREMENT D'ELEMENTS METALLIQUES**

VORRICHTUNG ZUR ERKENNUNG UND ZÄHLUNG VON METALLELEMENTEN

DEVICE FOR DETECTING AND COUNTING METAL ELEMENTS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **12.05.2010 FR 1053729**

(43) Date de publication de la demande:
**20.03.2013 Bulletin 2013/12**

(73) Titulaire: **Senstronic (Société Par Actions
Simplifiée)
67700 Saverne (FR)**

(72) Inventeur: **KIRCHDOERFFER, Rémy
CH-1117 Grancy (CH)**

(74) Mandataire: **Nuss, Laurent et al
Cabinet Nuss
10, rue Jacques Kablé
67080 Strasbourg Cedex (FR)**

(56) Documents cités:
**DE-U1- 29 808 830     US-A1- 2001 020 846**

## Description

La présente invention concerne le domaine de la détection de présence ou de proximité d'éléments, objets ou articles métalliques, plus particulièrement ferromagnétiques, et plus spécifiquement dans un environnement industriel.

L'invention a plus particulièrement pour objet un dispositif de détection d'éléments métalliques en plaques, plus particulièrement un dispositif dit de détection de double tôles, ainsi qu'un système de prélèvement et de transfert de tels éléments.

Lors de la réalisation de parties métalliques en tôles, ces dernières sont amenées à proximité du poste de découpe, d'emboutissage, de pliage ou autre, sous la forme d'éléments plans empilés.

Elles doivent alors être prélevées une à une pour être amenées vers ou dans le poste de traitement, ou sur une bande d'alimentation d'un tel poste.

A cette occasion, il y a lieu de garantir que les tôles sont amenées individuellement pour éviter tout dysfonctionnement ou arrêt du poste de traitement pouvant être provoqué par le traitement simultané de deux ou plusieurs tôles empilées.

Pour écarter ce risque, divers dispositifs de détection d'éléments métalliques en plaques tels que des tôles ou feuilles métalliques, destinés notamment à coopérer avec ou à être intégrés à un système de prélèvement, de déplacement, de transfert et/ou de positionnement ou analogue de tels éléments, ont déjà été proposés.

Ainsi, par le document DE 3505671, on connaît un dispositif de mesure de l'épaisseur d'une tôle par la détermination de la modification de l'inductance d'un électro-aimant et, par le document DE 3425354, on connaît un dispositif de mesure de l'épaisseur d'une tôle en utilisant les courants de Foucault, ce par la détermination d'une tension différentielle entre la tension relevée aux bornes d'une bobine de détection et une tension de référence.

Les procédés mis en oeuvre dans ces documents sont complexes et reposent sur l'évaluation et l'interprétation de la valeur d'une mesure analogique absolue, d'où il résulte une fiabilité incertaine. De plus, aucune réalisation constructive d'un dispositif matériel n'est divulguée par ces documents.

Par le document DE 298 08 830, on connaît un appareil pour repérer des pièces métalliques, cet appareil comportant des bobines d'émission et de réception qui peuvent être positionnées entre elles selon différentes configurations.

Par le document US 2001/0020846, on connaît un capteur de position pour déterminer la situation d'un élément métallique par rapport à un ensemble de bobines d'émission et de réception inclinées l'une par rapport à l'autre.

Toutefois, aucun de ces deux dispositifs connus n'exploite l'amplitude du signal recueilli, ni a fortiori ne permet de déterminer le nombre de pièces ou d'éléments détecté(e)s.

On connaît, par ailleurs, des dispositifs détecteurs dits "de double tôles" qui sont principalement constitués chacun, d'une part, par une bobine émettrice alimentée par des moyens de commande adaptés et générant un champ magnétique, d'autre part, par une bobine de réception ou réceptrice disposée de manière à permettre la génération par induction d'une tension aux bornes de ladite bobine sous l'action du champ magnétique précité et, enfin, par des moyens de traitement et d'évaluation du signal de tension fourni par ladite au moins une bobine de réception, permettant de fournir un signal informatif indiquant l'absence ou la présence d'un ou de plusieurs éléments métalliques à proximité desdites bobines.

Dans ces détecteurs de double tôles connus et mis en oeuvre notamment dans le cadre de la construction automobile, la tôle ou le bord de la tôle doit obligatoirement passer dans l'intervalle entre les deux bobines, ces dernières étant disposées en regard.

Cette contrainte ralentit le déplacement des tôles manipulées et nécessite un positionnement précis, avec un déplacement selon une trajectoire additionnelle, voire un poste de contrôle spécifique au niveau du moyen d'alimentation du poste ou de la machine de traitement desdites tôles.

En outre, ces détecteurs double tôles connus à bobines opposées présentent un encombrement important.

La présente invention a pour but de pallier les inconvénients précités.

A cet effet, l'invention a pour objet un dispositif de détection d'éléments métalliques en plaques tels que des tôles ou feuilles métalliques, destiné notamment à coopérer avec ou à être intégré à un système de prélèvement, de déplacement, de transfert et/ou de positionnement ou analogue de tels éléments,

dispositif principalement constitué, d'une part, par une bobine d'émission ou émettrice alimentée par des moyens de commande adaptés et générant un champ magnétique, d'autre part, par une bobine de réception ou réceptrice disposée de manière à permettre la génération par induction d'une tension aux bornes de ladite bobine sous l'action du champ magnétique précité et, enfin, par des moyens de traitement et d'évaluation du signal de tension fourni par ladite au moins une bobine de réception, permettant de fournir un signal informatif indiquant l'absence ou la présence d'un ou de plusieurs éléments métalliques à proximité desdites bobines,

ces bobines étant positionnées avec une inclinaison déterminée l'une par rapport à l'autre, de telle manière que le couplage magnétique entre les deux bobines est modifié par la présence d'un ou de plusieurs éléments métalliques à proximité,

dispositif caractérisé en ce que la bobine d'émission et la bobine de réception sont toutes deux montées dans un boîtier ou une tête de capteur présentant une face active de détection avec une zone de détection associée, et sont positionnées avec une inclinaison déterminée et par rapport à ladite face, et en ce que l'ampleur de la modification de l'amplitude et/ou de la puissance du signal de tension aux bornes de la bobine de réception due à la présence d'un ou de plusieurs éléments métalliques à proximité de ladite face active est relevée et exploitée par les moyens de traitement et d'évaluation, pour déterminer le nombre d'éléments métalliques en plaques présents.

Grâce à ces dispositions, il n'est plus nécessaire de faire passer les tôles ou les bords des tôles entre les deux bobines émettrices et réceptrices, un simple passage de leurs bords à proximité de la face active du capteur faisant partie du dispositif de détection, dans la zone de détection, étant suffisant. Un tel positionnement momentané des tôles peut aisément être intégré dans un mouvement de déplacement global desdites tôles, éventuellement sans modification de la trajectoire, avec éventuellement uniquement un léger décalage ou retard dans l'exécution dudit mouvement. De plus, la manière dont les éléments sont amenés et le parcours effectué par ces éléments sont indifférents.

L'invention repose essentiellement sur la constatation surprenante de l'inventeur que, pour la discrimination simple tôle / tôles multiples, la présence d'une partie périphérique ou du bord des tôles dans la zone de détection était suffisante pour aboutir à un résultat fiable, ce compte tenu également de la nature discrète de l'exploitation du signal relevé (détermination d'un nombre d'unités présentes, a priori similaires).

Par positionnement mutuel incliné des bobines, on entend dans la présente un positionnement mutuel relatif, tel que les axes de symétrie ou axes centraux XE et XR des bobines d'émission et de réception, axes préférentiellement coplanaires, sont sécants et forment entre eux un angle compris théoriquement entre 0° (axes parallèles) et 180° (axes confondus - bobines mutuellement en regard), pratiquement entre environ 45° et environ 135°, préférentiellement entre environ 75° et 105°.

En outre, les bobines sont disposées relativement proches l'une de l'autre de telle manière qu'en l'absence d'élément métallique dans la zone de détection, et compte tenu de l'orientation mutuelle relative desdites bobines, un couplage électromagnétique suffisant existe entre elles pour fournir un signal de réception dont les variations sont significatives et exploitables en présence d'élément(s) métallique(s).

Préférentiellement, les bobines d'émission et de réception sont arrangées selon une configuration telle que, vues en coupe selon un plan contenant leurs axes de symétrie respectifs, elles forment avec la face active de détection sensiblement un triangle rectangle, dont ladite face active constitue l'hypoténuse.

En outre, le dispositif selon l'invention peut également présenter une ou plusieurs des caractéristiques ou variantes constructives suivantes :

- les bobines d'émission et de réception peuvent être arrangés à proximité immédiate l'une de l'autre de telle manière que, même en l'absence d'élément métallique dans la zone de détection, un couplage électromagnétique suffisant existe entre elles pour fournir un signal de réception dont les variations sont significatives et exploitables en présence d'un ou de plusieurs éléments métalliques, même lorsque seule une partie périphérique ou un bord dudit ou desdits élément(s) est présent dans la zone de détection.

- les bobines d'émission et de réception peuvent être montées dans ou sur un corps support, assurant leur positionnement incliné l'une par rapport à l'autre, par exemple sensiblement perpendiculairement l'une par rapport à l'autre, ledit corps support définissant, le cas échéant, également matériellement la face active de détection ;

- la bobine d'émission peut être constituée de deux bobines élémentaires accolées et coaxiales, actives de manière alternative ;

- les bobines d'émission et de réception peuvent être logées dans une tête de capteur faisant partie d'un capteur dont le boîtier renferme au moins une partie des moyens de commande et des moyens de traitement et d'évaluation ;

- les moyens de commande peuvent alimenter la bobine d'émission avec un signal de fréquence (fosc) déterminée, adaptée au matériau constituant les éléments métalliques en plaques à détecter ;

- un condensateur de capacité $C_R$ peut être monté en parallèle de la bobine de réception d'inductance $L_R$, $C_R$ et $L_R$ étant tels que :

$$L_R \times C_R \times (2 \times \Pi \times fosc)^2 = 1 \; ;$$

- les moyens de traitement et d'évaluation peuvent comprendre des moyens de filtrage, préférentiellement de type passe-bande, et éventuellement d'amplification de la tension alternative recueillie aux bornes de la bobine de réception, des moyens de démodulation du signal filtré et amplifié, des moyens de conversion analogique/numérique traitant l'amplitude du signal démodulé et, le cas échéant, de comparaison de la valeur du signal démodulé et converti avec une valeur de référence prédéfinie, préenregistrée ou communiquée, par exemple correspondant à la présence d'un unique élément métallique en plaque dans la zone de détection associée à la face active du capteur ;

- les moyens de traitement et d'évaluation peuvent comprendre un circuit apte à délivrer un signal de cadencement ou d'horloge aux moyens de commande de la bobine émettrice, de manière à synchroniser l'excitation de cette dernière avec l'acquisition du signal de réception, et/ou

- une pièce formant ferrite peut être associée à la bobine émettrice et/ou à la bobine réceptrice.

L'invention concerne également un système de prélèvement et de transfert d'éléments métalliques en plaques, superposés en tas, ledit système comportant au moins un organe de manipulation, par exemple du type bras robot muni de ventouses ou d'un moyen de saisie magnétique, prélevant lesdits éléments un à un et les déplaçant selon une trajectoire déterminée, système caractérisé en ce qu'il comprend également un dispositif de détection tel que décrit ci-dessus, installé de telle manière qu'au cours du déplacement d'un élément métallique prélevé par l'organe de manipulation l'un des bords latéraux au moins de l'élément métallique se trouve positionné dans la zone de détection associée à la face active du boîtier ou de la tête de capteur dudit dispositif de détection.

L'invention sera mieux comprise, grâce à la description ci-après, qui se rapporte à des modes de réalisation préférés, donnés à titre d'exemples non limitatifs, et expliqués avec référence aux dessins schématiques annexés, dans lesquels :

La figure 1 est un schéma synoptique d'un dispositif de détection selon l'invention, aucun élément métallique en plaque n'étant présent dans la zone de détection ;
Les figures 2A et 2B sont des vues de détails schématiques illustrant la modification de la configuration des lignes de champ et du couplage électromagnétique en présence d'une tôle (figure 2A) et de deux tôles (figure 2B);
Les figures 3A et 3B sont des vues en coupe illustrant un arrangement de bobines dans une tête de capteur faisant partie de modes de réalisation pratiques du dispositif selon l'invention ;
Les figures 4 à 6 sont des représentations schématiques de trois variantes de réalisation de moyens de commande d'une bobine émettrice faisant partie du dispositif selon l'invention, ainsi que les chronogrammes ou signaux de commande associés, et,
La figure 7 est une représentation schématique d'un mode de réalisation de moyens de filtrage et de prétraitement faisant partie du dispositif selon l'invention.

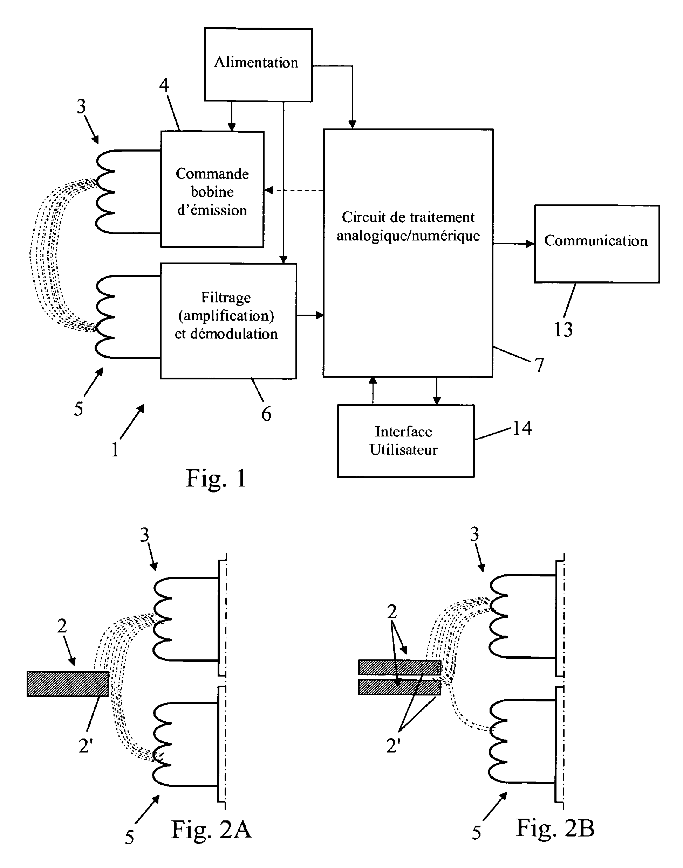

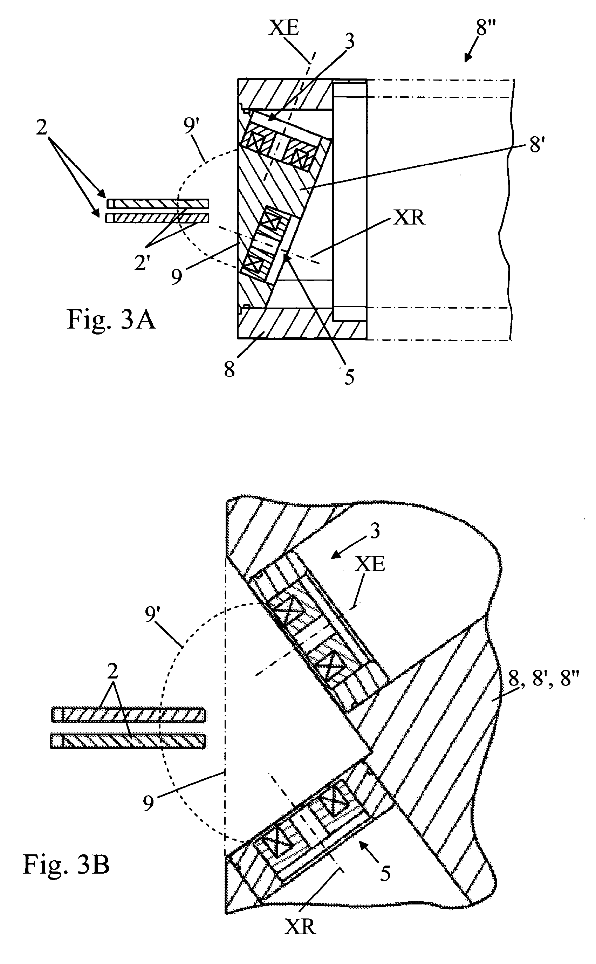

La figure 1 et partiellement les figures 3 illustrent un dispositif 1 de détection d'éléments métalliques en plaques 2 tels que des tôles ou feuilles métalliques, destiné notamment à coopérer avec ou à être intégré à un système de prélèvement, de déplacement, de transfert et/ou de positionnement ou analogue de tels éléments.
Ce dispositif 1 est principalement constitué, d'une part, par une bobine 3 d'émission ou émettrice alimentée par des moyens de commande 4 adaptés et générant un champ magnétique, d'autre part, par une bobine 5 de réception ou réceptrice disposée de manière à permettre la génération par induction d'une tension aux bornes de ladite bobine 5 sous l'action du champ magnétique précité et, enfin, par des moyens 6, 7 de traitement et d'évaluation du signal de tension fourni par ladite au moins une bobine de réception 5, permettant de fournir un signal informatif indiquant l'absence ou la présence d'un ou de plusieurs éléments métalliques 2 à proximité desdites bobines 3, 5.
Ces bobines 3, 5 sont positionnées avec une inclinaison déterminée l'une par rapport à l'autre, de telle manière que le couplage magnétique entre les deux bobines (3 et 5) est modifié par la présence d'un ou de plusieurs éléments métalliques (2) à proximité.
Conformément à l'invention, la bobine d'émission 3 et la bobine de réception 5 sont toutes deux montées dans un boîtier ou une tête de capteur 8 présentant une face active 9 de détection avec une zone de détection 9' associée, et sont positionnées avec une inclinaison déterminée et par rapport à ladite face 9, et en ce que l'ampleur de la modification de l'amplitude et/ou de la puissance du signal de tension aux bornes de la bobine de réception 5 due à la présence d'un ou de plusieurs éléments métalliques 2 à proximité de ladite face active 9 est relevée et exploitée par les moyens 6, 7 de traitement et d'évaluation, pour déterminer le nombre d'éléments métalliques en plaques 2 présents.
Préférentiellement, les bobines 3 et 5 d'émission et de réception sont arrangées selon une configuration telle que, vues en coupe selon un plan contenant leurs axes de symétrie (XE et XR) respectifs, elles forment avec la face active de détection 9 sensiblement un triangle rectangle, dont ladite face active 9 constitue l'hypoténuse.
Comme le montrent les figures 3A et 3B et de manière pratique, les bobines d'émission 3 et de réception 5 sont montées dans ou sur un corps support 8', assurant leur positionnement incliné l'une par rapport à l'autre, par exemple sensiblement perpendiculairement l'une par rapport à l'autre, ledit corps support 8' définissant, le cas échéant, également matériellement la face active de détection 9.
La face active 9 de détection, généralement considérée comme étant une surface plane, peut être confondue en totalité avec la face matérielle sensiblement plane de la tête de capteur 8 ou du boîtier de capteur 8", fournissant ou renfermant le corps support 8', comme le montre la figure 3A.
La configuration matérielle du corps support 8' et/ou de la tête 8 ou du boîtier 8" du capteur peut également être non plane, par exemple renfoncée (figure 3B), les bobines 3 et 5 étant éventuellement positionnées de manière affleurante dans un renfoncement ou une cavité similaire de la face du capteur concernée.
Dans ce dernier cas, le corps support 8' peut, le cas échéant, être réalisé en un matériau métallique, et éventuellement être réalisé de manière monobloc avec le boîtier et/ou la tête de capteur. Les bobines 3 et 5 peuvent alors être positionnées (avec leur encapsulation plastique) dans des ouvertures ménagées dans ce corps 8' (figure 3B).

L'inventeur a constaté qu'avec le dispositif 1 selon l'invention, la variation de l'amplitude du signal relevé au niveau de la bobine de réception 5 est peu dépendante de l'épaisseur de l'élément en plaque 2 présenté au niveau de la face active 9.

Au contraire, la variation du signal constatée au niveau de la bobine de réception 5 est significative, dès que plusieurs éléments 2 en plaques, tels que des tôles (même empilées), sont présentés à proximité de la face active 9 et cela que les bords 2' des tôles soient alignés ou pas. Il a en effet été constaté qu'une marge de quelques millimètres en retrait ou en avant est admise par le dispositif 1 qui continue malgré cela à détecter correctement la présence de plusieurs tôles 2.

Le mode de fonctionnement du dispositif 1 selon l'invention est décrit plus en détails ci-après, en relation avec les figures annexées et sur la base de différentes variantes de réalisation de certaines parties dudit dispositif 1.

Un champ magnétique est produit par l'intermédiaire de la bobine d'émission 3 excitée de manière adaptée (une ferrite peut être utilisée pour concentrer les lignes de champ produite par la bobine d'émission).

Cette bobine d'émission 3 est commandée par l'intermédiaire de moyens 4 adaptés comprenant des commutateurs et/ou des amplificateurs, configurés pour alimenter ladite bobine d'émission 3 avec une fréquence fosc (plusieurs configurations sont possibles : Pont en H, ...).

Le cas échéant, les commutateurs précités peuvent être directement commandés à la fréquence fosc par le circuit 7 de traitement analogique/numérique (du type microcontrôleur, ASIC, DSP ou autre), permettant ainsi de synchroniser l'acquisition (échantillonnage) du signal de réception avec l'envoi des impulsions de la bobine d'émission 3 (détection synchrone).

Néanmoins, les commutateurs peuvent en variante être commandés via un circuit indépendant du circuit 7 de traitement analogique/numérique (par exemple un générateur d'impulsions) qui oscille à la fréquence fosc choisie. La détection synchrone n'est en effet pas indispensable pour détecter de manière fiable par l'intermédiaire du dispositif 1.

La composante alternative du champ magnétique produit par la bobine d'émission 3 induit une tension alternative dans la bobine de réception 5.

Une fréquence fosc d'environ 2 kHz convient bien à la détection de tôles en acier, mais d'autres fréquences peuvent être choisies pour procéder à la détection d'autres matériaux.

L'amplitude de la tension alternative présente aux bornes de la bobine de réception 5 est fonction :

- de l'amplitude de tension d'alimentation de la bobine d'émission 3 ;
- de l'impédance du circuit à laquelle est raccordée la bobine de réception 5 ;

- du milieu métallique qui avoisine les bobines 3 et 5.

Il convient de noter qu'une ferrite peut être utilisée pour concentrer les lignes de champ captées par la bobine de réception 5.

Afin d'obtenir un signal facilement exploitable et d'amplitude maximale, il est préférable de raccorder en parallèle à la bobine de réception 5 d'inductance $L_R$, un condensateur $C_R$ de telle sorte que soit respecté le critère :

$$L_R \times C_R \times (2 \times \Pi \times fosc)^2 = 1.$$

La tension alternative recueillie aux bornes de la bobine de réception 5 est ensuite traitée par des moyens adaptés 6 pour être filtrée et amplifiée (de préférence à l'aide d'un filtre passe bande pour éliminer les fréquences parasites de type fréquence secteur et/ou interférences RF), puis démodulée afin de pouvoir exploiter l'amplitude du signal de réception via le circuit 7 de conversion et de traitement analogique/numérique.

En fonction de la nature du milieu métallique (présence de tôles 2 ou de tout autre objet métallique), le signal relevé aux bornes de la bobine de réception 5 va être plus ou moins atténué.

Ainsi, en présence du rebord 2' d'une tôle 2 (ou de plusieurs tôles, plaquées ou pas les unes aux autres), le signal perçu par la bobine et le circuit de réception est atténué.

Comme indiqué précédemment, l'atténuation du signal de réception dépend très peu de l'épaisseur de la (ou des) tôle(s) 2 présentée(s) et dépend principalement, voire exclusivement, du nombre de tôles 2 détectées.

En effet, du fait que les lignes de champ magnétique qui longent les tôles 2 produisent des courants induits dans ces tôles 2, chaque tôle 2 devient un consommateur d'énergie et constitue de ce fait un récepteur qui vient "concurrencer" la bobine de réception 5.

La présence de plusieurs tôles 2 est ainsi équivalente à la mise en parallèle de plusieurs circuits consommateurs d'énergie.

Ainsi, plus il y a de tôles 2 présentées aux abords (zone de détection 9') du couple de bobines émission/réception 3 et 5, plus le couplage électromagnétique qui lie la bobine d'émission 3 à la bobine de réception 5 sera faible et, de ce fait, plus le signal perçu par la bobine de réception 5 sera atténué.

Dans le cas de plusieurs tôles, les inventeurs ont pu constater que le fait que celles-ci soient ou non plaquées les unes contre les autres, ou que celles-ci soient ou non décalées (de quelques millimètres) les unes par rapport aux autres, ne modifie en rien la capacité du dispositif 1 à détecter la présence de plusieurs tôles 2 de même matière, et cela que leurs épaisseurs soient identiques ou non.

En comparant le niveau du signal de réception à un environnement de référence (présence d'une seule tôle 2 par exemple), il est défini (par l'intermédiaire du circuit 7 de traitement analogique/numérique) un niveau de référence.

Ce niveau de référence est ensuite comparé à tout autre niveau lié à la présence ou non de tôles.

Il devient ainsi possible de comparer le niveau du signal de réception mesuré au niveau de référence et d'avertir, par l'intermédiaire d'un élément ou circuit de communication 13 par exemple, de la présence de plusieurs tôles.

Le niveau de référence peut être défini lors de la fabrication ou via l'utilisateur (par une interface utilisateur 14) ou par tout autre moyen de communication si le dispositif 1 en est doté.

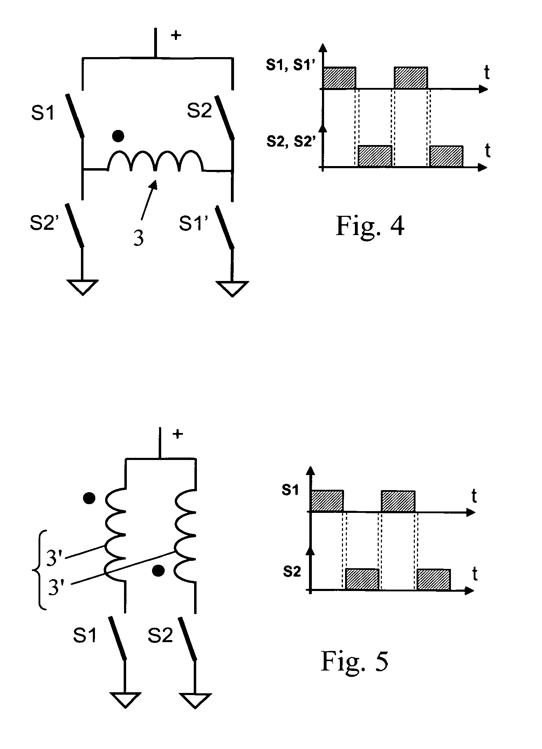

Les figures 4 à 6 illustrent différentes variantes de réalisation du circuit de commande 4, ainsi que les chronogrammes des signaux d'actionnement respectivement associés.

Comme le montrent les figures 4 et 5, un signal "carré" de période 1/fosc peut être appliqué à la bobine d'émission 3 (avec ou sans modulation de largeur d'impulsion), par exemple par l'intermédiaire des commutateurs S1, S2, S1' et S2' d'un pont en H (figure 4), ou encore par l'intermédiaire d'une structure (figure 5) qui minimise le nombre de commutateurs électroniques du fait de l'utilisation de deux bobines d'émission 3' sollicitées chacune sur une demi-période par des commutateurs S1 et S2 associés.

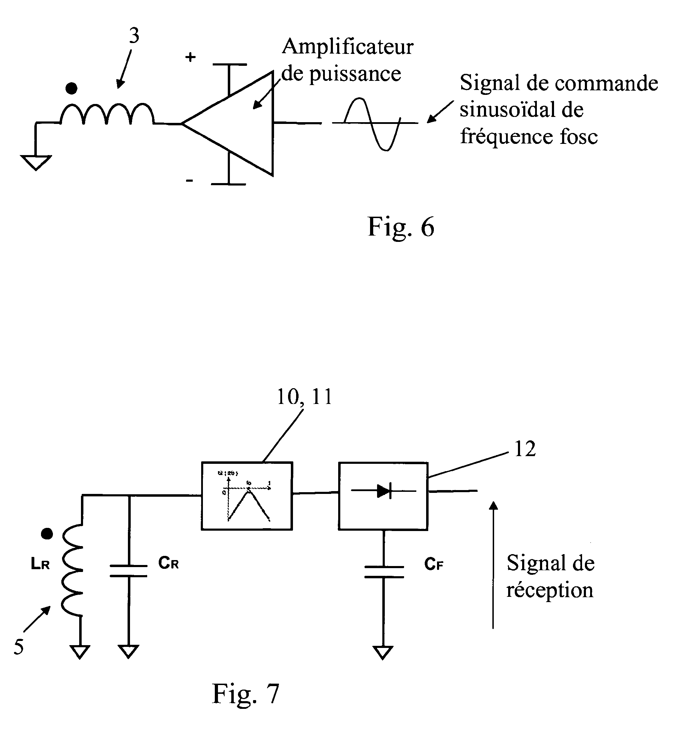

En variante, et comme le montre la figure 6, le circuit de commande 4 peut également appliquer un signal sinusoïdal de fréquence fosc à la bobine d'émission 3, éventuellement après amplification.

La figure 7 illustre de manière schématique une variante de réalisation possible des moyens de prétraitement 6, incluant un circuit de filtrage et un circuit de démodulation, l'amplification n'étant pas forcément obligatoire lorsqu'un condensateur $C_R$ est mis en parallèle avec la bobine de réception 5.

**Revendications**

1. Dispositif de détection d'éléments métalliques en plaques tels que des tôles ou feuilles métalliques, destiné notamment à coopérer avec ou à être intégré à un système de prélèvement, de déplacement, de transfert et/ou de positionnement ou analogue de tels éléments, dispositif principalement constitué, d'une part, par une bobine d'émission ou émettrice (3) alimentée par des moyens de commande adaptés et générant un champ magnétique, d'autre part, par une bobine de réception ou réceptrice (5) disposée de manière à permettre la génération par induction d'une tension aux bornes de ladite bobine sous l'action du champ magnétique précité et, enfin, par des moyens (6, 7) de traitement et d'évaluation du signal de tension fourni par ladite au moins une bobine de réception (5), permettant de fournir un signal informatif indiquant l'absence ou la présence d'un ou de plusieurs éléments métalliques (2) à proximité desdites bobines (3, 5),

ces bobines (3 et 5) étant positionnées avec une inclinaison déterminée, de telle manière que le couplage magnétique entre les deux bobines (3 et 5) est modifié par la présence d'un ou de plusieurs éléments métalliques (2) à proximité,

dispositif (1) **caractérisé en ce que** la bobine d'émission (3) et la bobine de réception (5) sont toutes deux montées dans un boîtier ou une tête de capteur (8) présentant une face active (9) de détection avec une zone de détection (9') associée, et sont positionnées avec une inclinaison déterminée l'une par rapport à l'autre et par rapport à ladite face (9), et **en ce que** l'ampleur de la modification de l'amplitude et/ou de la puissance du signal de tension aux bornes de la bobine de réception (5) due à la présence d'une partie périphérique ou du bord d'un ou de plusieurs éléments métalliques (2) à proximité de ladite face active (9) est relevée et exploitée de manière discrète par les moyens (6, 7) de traitement et d'évaluation, pour déterminer le nombre d'éléments métalliques en plaques (2) présents.

2. Dispositif de détection selon la revendication 1, **caractérisé en ce que** les bobines (3 et 5) d'émission et de réception sont arrangées selon une configuration telle que, vues en coupe selon un plan contenant leurs axes de symétrie (XE et XR) respectifs, elles forment avec la face active de détection (9) sensiblement un triangle rectangle, dont ladite face active (9) constitue l'hypoténuse.

3. Dispositif de détection selon la revendication 1 ou 2, **caractérisé en ce que** les bobines d'émission (3) et de réception (5) sont arrangées à proximité immédiate l'une de l'autre de telle manière que, même en l'absence d'élément métallique (2) dans la zone de détection (9'), un couplage électromagnétique suffisant existe entre elles pour fournir un signal de réception dont les variations sont significatives et exploitables en présence d'un ou de plusieurs éléments métalliques (2), même lorsque seule une partie périphérique ou un bord dudit ou desdits élément (s) (2) est présent dans la zone de détection (9').

4. Dispositif de détection selon l'une quelconque des revendications 1 à 3, **caractérisé en ce que** les bobines d'émission (3) et de réception (5) sont montées dans ou sur un corps support (8'), assurant leur positionnement incliné l'une par rapport à l'autre, par exemple sensiblement perpendiculairement l'une par rapport à l'autre, ledit corps support (8') définissant, le cas échéant, également matériellement la face active de détection (9).

**5.** Dispositif de détection selon l'une quelconque des revendications 1 à 4, **caractérisé en ce que** la bobine d'émission (3) est constituée de deux bobines élémentaires (3') accolées et coaxiales, actives de manière alternative.

**6.** Dispositif de détection selon l'une quelconque des revendications 1 à 5, **caractérisé en ce que** les bobines d'émission (3) et de réception (5) sont logées dans une tête de capteur (8) faisant partie d'un capteur dont le boîtier (8") renferme au moins une partie des moyens (4) de commande et des moyens (6, 7) de traitement et d'évaluation.

**7.** Dispositif de détection selon l'une quelconque des revendications 1 à 6, **caractérisé en ce que** les moyens de commande (4) alimentent la bobine d'émission (3) avec un signal de fréquence (fosc) déterminée, adaptée au matériau constituant les éléments métalliques (2) en plaques à détecter.

**8.** Dispositif de détection selon la revendication 7, **caractérisé en ce qu'**un condensateur de capacité $C_R$ est monté en parallèle de la bobine de réception (5) d'inductance $L_R$, $C_R$ et $L_R$ étant tels que :

$$L_R \times C_R \times (2 \times \Pi \times fosc)^2 = 1.$$

**9.** Dispositif de détection selon l'une quelconque des revendications 1 à 8, **caractérisé en ce que** les moyens de traitement et évaluation (6, 7) comprennent des moyens de filtrage (10), préférentiellement de type passe-bande, et éventuellement d'amplification (11) de la tension alternative recueillie aux bornes de la bobine de réception (5), des moyens de démodulation (12) du signal filtré et amplifié, des moyens (7) de conversion analogique/numérique traitant l'amplitude du signal démodulé et, le cas échéant, de comparaison de la valeur du signal démodulé et converti avec une valeur de référence prédéfinie, préenregistrée ou communiquée, par exemple correspondant a la présence d'un unique élément métallique en plaque (2) dans la zone de détection (9') associée à la face active (9) du capteur.

**10.** Dispositif de détection selon l'une quelconque des revendications 1 à 9, **caractérisé en ce que** les moyens de traitement et d'évaluation (6, 7) comprennent un circuit apte à délivrer un signal de cadencement ou d'horloge aux moyens de commande (4) de la bobine émettrice (3), de manière à synchroniser l'excitation de cette dernière avec l'acquisition du signal de réception.

**11.** Dispositif de détection selon l'une quelconque des revendications 1 à 10, **caractérisé en ce qu'**une pièce formant ferrite est associée à la bobine émettrice (3) et/ou à la bobine réceptrice (5).

**12.** Système de prélèvement et de transfert d'éléments métalliques en plaques, superposés en tas, ledit système comportant au moins un organe de manipulation, par exemple du type bras robot muni de ventouses ou d'un moyen de saisie magnétique, prélevant lesdits éléments un à un et les déplaçant selon une trajectoire déterminée, système **caractérisé en ce qu'**il comprend également un dispositif (1) de détection selon l'une quelconque des revendications 1 à 11, installé de telle manière qu'au cours du déplacement d'un élément métallique (2) prélevé par l'organe de manipulation l'un des bords latéraux (2') au moins de l'élément métallique (2) se trouve positionné dans la zone de détection (9') associée à la face active (9) du boîtier ou de la tête de capteur (8) dudit dispositif de détection (1).

**Patentansprüche**

**1.** Vorrichtung zur Erkennung von metallischen plattenförmigen Elementen wie Metallblechen oder Metallfolien, die insbesondere zum Zusammenwirken mit einem System zur Entnahme, zur Bewegung, zur Überführung und/oder Positionierung oder Ähnlichem derartiger Elemente bestimmt oder in dieses System integriert ist,
wobei die Vorrichtung hauptsächlich einerseits durch eine Sende-Spule oder einen Sender (3), der durch geeignete Steuereinrichtungen gespeist ist und ein Magnetfeld erzeugt, und andererseits durch eine Empfangs-Spule oder einen Empfänger (5), der derart angeordnet ist, dass er die Erzeugung einer Spannung durch Induktion an den Klemmen der Spule unter der Wirkung des genannten Magnetfeldes ermöglicht, und schließlich durch Einrichtungen (6, 7) zur Verarbeitung und Auswertung des Spannungssignals gebildet ist, das durch die zumindest eine Empfangsspule (5) geliefert wird, und die Lieferung eines Informationssignals ermöglicht, das das Fehlen oder das Vorhandensein eines oder mehrerer metallischer Elemente (2) in der Nähe dieser Spulen (3, 5) ermöglicht,
wobei diese Spulen (3 und 5) mit einer vorgegebenen Neigung derart angeordnet sind, dass die magnetische Kopplung zwischen den beiden Spulen (3 und 5) durch das Vorhandensein von einem oder mehreren metallischen Elementen (2) in der Nähe modifiziert wird,
Vorrichtung (1) **dadurch gekennzeichnet, dass** die Sende-Spule (3) und die Empfangs-Spule (5) alle beide in einem Gehäuse oder in einem Detektor-Kopf (8), der eine aktive Detektions-Fläche (9) mit einer zugehörigen Detektions-Zone (9') aufweist, befestigt und mit einer vorgegebenen Neigung bezüglich einander und bezüglich der Fläche (9) angeordnet sind, und dass die Größe der Modifikation der Amplitude und/oder der Leistung des Spannungssignals an den Klemmen der Empfangs-Spule (5) aufgrund des Vorhandenseins eines Umfangsteils oder einer Kante eines oder mehrerer metallischer Elemente in der Nähe der aktiven Fläche (9) erfasst und in diskreter Weise durch die Einrichtungen (6, 7) zur Verarbeitung und Auswertung ausgenutzt wird, um die Anzahl der vorhandenen metallischen plattenförmigen Elemente (2) zu bestimmen.

2. Vorrichtung zur Erkennung nach Anspruch 1, **dadurch gekennzeichnet, dass** die Sende- und Empfangs-Spulen (3 und 5) in einer derartigen Konfiguration angeordnet sind, das bei Betrachtung im Schnitt entlang einer Ebene, die ihre jeweiligen Symmetrieachsen (XE und XR) enthält, sie zusammen mit der aktiven Detektions-Fläche (9) im Wesentlichen ein rechtwinkliges Dreieck bilden, von dem die aktive Fläche (9) die Hypotenuse bildet.

3. Vorrichtung zur Erkennung nach Anspruch 1 oder 2, **dadurch gekennzeichnet, dass** die Sende- (3) und Empfangs- (5) Spulen in unmittelbarer Nähe zueinander derart angeordnet sind, dass selbst bei Fehlen eines metallischen Elementes (2) in der Detektions-Zone (9') eine ausreichende elektromagnetische Kopplung zwischen diesen vorhanden ist, um ein Empfangssignal zu liefern, dessen Änderungen das Vorhandensein von einem oder mehreren metallischen Elementen (2) anzeigen und auswertbar sind, selbst wenn nur ein Umfangsteil oder eine Kante des oder der Elemente (2) in der Detektions-Zone (9') vorhanden ist.

4. Vorrichtung zur Erkennung nach einem der Ansprüche 1 bis 3, **dadurch gekennzeichnet, dass** die Sende- (3) und Empfangs- (5) Spulen in oder auf einem Trägerkörper (8') montiert sind, der ihre geneigte Positionierung bezüglich einander sicherstellt, beispielsweise im Wesentlichen senkrecht zueinander, wobei dieser Trägerkörper (8') gegebenenfalls ebenfalls materiell die aktive Detektions-Fläche (9) bildet.

5. Vorrichtung zur Erkennung nach einem der Ansprüche 1 bis 4, **dadurch gekennzeichnet, dass** die Sende-Spule (3) durch zwei Teilspulen (3') gebildet ist, die zusammengefügt und koaxial sind und in abwechselnder Weise aktiviert werden.

6. Vorrichtung zur Erkennung nach einem der Ansprüche 1 bis 5, **dadurch gekennzeichnet, dass** die Sende- (3) und Empfangs- (5) Spulen in einem Detektor-Kopf (8) angeordnet sind, der einen Teil eines Detektors bildet, dessen Gehäuse (8") zumindest einen Teil der Steuereinrichtungen (4) und der Verarbeitungs- und Auswerteeinrichtungen (6, 7) umschließt.

7. Vorrichtung zur Erkennung nach einem der Ansprüche 1 bis 6, **dadurch gekennzeichnet, dass** die Steuereinrichtungen (4) die Sende-Spule (3) mit einem Signal mit einer vorgegebenen Frequenz (fosc) speisen, die an das Material angepasst ist, das die zu erkennenden metallischen plattenförmigen Elemente (3) bildet.

8. Vorrichtung zur Erkennung nach Anspruch 7, **dadurch gekennzeichnet, dass** ein Kondensator mit einer Kapazität $C_R$ parallel zu der Empfangs-Spule (5) mit einer Induktivität $L_R$ befestigt ist, wobei $C_R$ und $L_R$ derart sind, dass

$$L_R \times C_R \times (2 \times \pi \times fosc)^2 = 1 \text{ ist.}$$

9. Vorrichtung zur Erkennung nach einem der Ansprüche 1 bis 8, **dadurch gekennzeichnet, dass** die Verarbeitungs- und Auswerteeinrichtungen (6, 7) Filtereinrichtungen (10), vorzugsweise von andpass-Typ, und gegebenenfalls zur Verstärkung (11) der Wechselspannung, die an den Klemmen der Empfangs-Spule (5) empfangen wird, Demodulationseinrichtungen (12) für das gefilterte und verstärkte Signal, Einrichtungen (7) zur Analog-/Digitalwandlung zur Behandlung der Amplitude des demodulierten Signals, und gegebenenfalls zum Vergleich des Wortes des demodulierten und umgewandelten Signals mit einem vordefinierten, vorher aufgezeichneten oder übermittelten Bezugssignals umfassen, das beispielsweise dem Vorhandensein eines einzigen metallischen plattenförmigen Elementes (2) in der Detektins-Zone (9) entspricht, die der aktiven Fläche (9) des Detektors zugeordnet ist.

10. Vorrichtung zur Erkennung nach einem der Ansprüche 1 bis 9, **dadurch gekennzeichnet, dass** die Verarbeitungs- und Auswerteeinrichtungen (6, 7) eine Schaltung umfassen, die zur Lieferung eines Schritt- oder Taktsignals an die Steuereinrichtungen (4) für die Sende-Spule (3) ausgebildet ist, derart, dass die Erregung der letzteren mit der Erfassung des Empfangs-Signals synchronisiert ist.

11. Vorrichtung zur Erkennung nach einem der Ansprüche 1 bis 10, **dadurch gekennzeichnet, dass** ein ein Ferritmaterial bildendes Teil der Sende-Spule (3) und/oder der Empfangs-Spule (5) zugeordnet ist.

12. System zur Entnahme und zur Überführung von plattenförmigen metallischen Elementen, die in einem Stapel übereinander angeordnet sind, wobei das System zumindest eine Einrichtung zur Manipulation, beispielsweise vom Typ eines Roboter-Arms aufweist, der mit Saugnäpfen oder magnetischen Greifereinrichtungen versehen ist, die die Elemente einzeln entnehmen und diese entlang einer vorgegebenen Bewegungsbahn bewegen, wobei das System **dadurch gekennzeichnet ist, dass** es außerdem eine Vorrichtung (1) zur Erkennung nach einem der Ansprüche 1 bis 11 umfasst, das derart installiert ist, das sich im Verlauf der Bewegung eines von dem Greifer- und Manipulationselement erfassten metallischen Elementes (2) zumindest eine der Seitenkanten (2') des metallischen Elementes (2) in der Detektions-Zone (9') befindet, die der aktiven Fläche (9) des Gehäuses oder des Detektor-Kopfes (8) der Vorrichtung zur Erkennung (1) zugeordnet ist.

## Claims

1. Device for detecting metal plate elements such as metal sheets or plates, intended in particular to work with or to be incorporated into a system for selection, movement, transfer and/or positioning or the like of such elements,
a device consisting mainly, on the one hand, of an emission or emitting coil (3) supplied by suitable control means and generating a magnetic field; on the other hand, of a reception or receiving coil (5) placed so as to make possible the generation by induction of a voltage at the terminals of said coil under the action of the aforementioned magnetic field, and, finally, of means (6, 7) for processing and evaluating the voltage signal provided by said at least one reception coil (5), making it possible to provide an informative signal indicating the absence or the presence of one or more metal elements (2) in the vicinity of said coils (3, 5),
these coils (3 and 5) being positioned with a specific inclination, in such a way that the magnetic coupling between the two coils (3 and 5) is changed by the presence of one or more nearby metal elements (2), a device (1) **characterized in that** the emission coil (3) and the reception coil (5) are both mounted in a case or a sensor head (8) having an active detection face (9) with a corresponding detection area (9'), and are positioned with a specific inclination in relation to one another and in relation to said face (9), and **in that** the magnitude of the change in the amplitude and/or in the power of the voltage signal at the terminals of the reception coil (5) due to the presence of a peripheral part or of the edge of one or more metal elements (2) near said active face (9) is picked up and used in a discrete manner by the processing and evaluation means (6, 7) to determine the number of metal plate elements (2) present.

2. Detection device according to Claim 1, **characterized in that** the emission and reception coils (3 and 5) are arranged according to a configuration such that, seen in section along a plane containing their respective axes of symmetry (XE and XR), they form with the active detection face (9) approximately a right triangle, whose said active face (9) constitutes the hypotenuse.

3. Detection device according to Claim 1 or 2, **characterized in that** the emission coil (3) and reception coil (5) are arranged in the immediate proximity of one another in such a way that, even in the absence of a metal element (2) in the detection area (9'), a sufficient electromagnetic coupling exists between them to provide a receiving signal whose variations are significant and usable in the presence of one or more metal elements (2), even when only a peripheral part or an edge of said element(s) (2) is present in the detection area (9').

4. Detection device according to any one of Claims 1 to 3, **characterized in that** the emission coil (3) and reception coil (5) are mounted in or on a support body (8'), ensuring their inclined positioning in relation to one another, for example approximately perpendicular in relation to one another, said support body (8') defining, if necessary, also materially the active detection face (9).

5. Detection device according to any one of Claims 1 to 4, **characterized in that** the emission coil (3) consists of two elementary coils (3') that are placed side by side and coaxial, active in an alternating manner.

6. Detection device according to any one of Claims 1 to 5, **characterized in that** the emission coil (3) and reception coil (5) are housed in a sensor head (8) that is part of a sensor whose case (8") contains at least a part of the control means (4) and of the processing and evaluation means (6, 7).

7. Detection device according to any one of Claims 1 to 6, **characterized in that** the control means (4) supply the emission coil (3) with a specific frequency signal (fosc), adapted to the material constituting the metal plate elements (2) to be detected.

8. Detection device according to Claim 7, **characterized in that** a capacitor of capacitance $C_R$ is mounted in parallel with the reception coil (5) of inductance $L_R$, $C_R$ and $L_R$ being such that:

$$L_R \times C_R \times (2 \times \Pi \times fosc)^2 = 1.$$

9. Detection device according to any one of Claims 1 to 8, **characterized in that** the processing and evaluation means (6, 7) comprise means for filtering (10), preferentially of the band-pass type, and optionally for amplification (11) of the AC voltage recovered at the terminals of the reception coil (5), means for demodulating (12) the filtered and amplified signal, means (7) for analog/digital conversion that process the amplitude of the demodulated signal and, if necessary, for comparison of the value of the demodulated and converted signal with a predefined, pre-entered or communicated reference value, for example corresponding to the presence of a single metal plate element (2) in the detection area (9') associated with the active face (9) of the sensor.

10. Detection device according to any one of Claims 1 to 9, **characterized in that** the processing and evaluation means (6, 7) comprise a circuit able to deliver a pace or timing signal to the control means (4) of the emitting coil (3), so as to synchronize the excitation of the latter with the acquisition of the receiving signal.

11. Detection device according to any one of Claims 1 to 10, **characterized in that** a ferrite-forming part is associated with the emitting coil (3) and/or with the receiving coil (5).

12. System for selecting and transferring metal plate elements, stacked in piles, said system comprising at least one manipulating element, for example of the robot arm type equipped with suction cups or with a means for magnetic seizing, selecting said elements one by one and moving them along a specific path, a system **characterized in that** it also comprises a detection device (1) according to any one of Claims 1 to 11, installed in such a way that during the movement of a metal element (2) selected by the manipulation element, at least one of the lateral edges (2') of the metal element (2) is positioned in the detection area (9') associated with the active face (9) of the case or of the sensor head (8) of said detection device (1).

Alimentation

Commande
bobine
d'émission

Filtrage
(amplification)
et démodulation

Circuit de traitement
analogique/numérique

Communication

Interface
Utilisateur

Fig. 1

Fig. 2A

Fig. 2B

Fig. 3A

Fig. 3B

Fig. 4

Fig. 5

3

+

Amplificateur
de puissance

−

Signal de commande
sinusoïdal de
fréquence fosc

## Fig. 6

10, 11

12

$L_R$

$C_R$

$C_F$

Signal de
réception

5

## Fig. 7

**EP 2 569 656 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 3505671
- DE 3425354
- DE 29808830
- US 20010020846 A